# EUROPÄISCHE PATENTSCHRIFT

(11) **EP 1 704 756 B1**
(45) Veröffentlichungstag und Bekanntmachung des Hinweises auf die Patenterteilung: **05.09.2007**
(21) Anmeldenummer: 05706679.7
(22) Anmeldetag: 14.01.2005
(51) Int. Cl.: H05H 1/46, C23C 16/509, H01J 37/32

(54) **PLASMABEHANDLUNG GROSSVOLUMIGER BAUTEILE**
PLASMA TREATMENT OF LARGE-SCALE COMPONENTS
TRAITEMENT PAR PLASMA DE COMPOSANTS A GRAND VOLUME

(30) Priorität: 15.01.2004 DE 102004002878
(43) Veröffentlichungstag der Anmeldung: 27.09.2006
(73) Patentinhaber: Dr. Laure Plasmatechnologie Gmbh, 70329 Stuttgart (DE)
(72) Erfinder: LAURE, Stefan, 70329 Stuttgart (DE)
(74) Vertreter: Lucht, Silvia
(86) Internationale Anmeldenummer: PCT/DE2005/000047
(87) Internationale Veröffentlichungsnummer: WO 2005/069703

(56) Entgegenhaltungen:
- EP-A- 1 354 640
- GB-A- 1 204 261
- US-A- 4 781 145
- US-A- 5 810 963
- US-A- 5 902 563
- US-A1- 2003 217 813

## Beschreibung

Die Erfindung geht aus von einer Vorrichtung und einem Verfahren zur Plasmabehandlung großvolumiger Bauteile mittels eines hochfrequenten elektromagnetischen Feldes.

Wird die Oberfläche eines Bauteils einem Plasma ausgesetzt, so können bei entsprechender Wahl der Plasmaparameter wie Druck, Temperatur und Plasmazusammensetzung die Funktionalität und die Eigenschaften der Oberfläche gezielt beeinflusst und verändert werden. Aus dem Stand der Technik sind Verfahren zur Behandlung, Modifizierung oder Beschichtung einer Oberfläche aus beliebigem Material bekannt, bei denen Teilchen- oder Energieströme aus einem Plasma genutzt werden. Hierzu zählen unter anderem Plasmaspritzen, Lichtbogenplasmaschmelzen, Plasmawärmebehandlungsverfahren, Plasma-CVD-Verfahren und Plasmareinigung. Die Veränderung der Funktionalität von Werkstückoberflächen erfolgt durch gezielten Angriff von Plasmateilchen. Dies kann durch die Wechselwirkung mit Teilchen mit bestimmten chemischen Eigenschaften oder durch die Einwirkung von Strahlung, die vom Plasma emittiert wird, geschehen.

Zur Erzeugung eines Plasmas wird ein Plasmabrenner verwendet. Beim Lichtbogen-Plasmabrenner wird ein strömendes Gas durch einen Lichtbogen ionisiert und auf Temperaturen von 10.000 bis 20.000 K aufgeheizt. Beim Hochfrequenz-Plasmabrenner wird das strömende Gas durch Anlegen eines hochfrequenten elektromagnetischen Feldes an eine zylindrische Spule ionisiert. In einem zylindrischen Entladungsgefäß, welches aus einem dielektrischen Material gefertigt ist, entsteht ein relativ dichtes Plasma mit hoher Energiedichte. Auch hier können Plasmatemperaturen von bis zu 20.000 K erreicht werden.

Die oben beschriebenen thermischen Plasmen eignen sich für die Bearbeitung von Bauteilen, die sich durch eine gewisse Temperaturelastbarkeit auszeichnen. Bei Bauteilen aus Kunststoff oder bei bereits lackierten Bauteilen, die einer maximalen Temperatur von nur 100-200°C ausgesetzt sein dürfen, können derartige Verfahren nicht eingesetzt werden.

Zur Erzeugung von dünnen Plasmen mit relativ geringen Energiedichten werden ebenfalls Hochfrequenzgeneratoren benutzt. Ihr Frequenzbereichbereich liegt zwischen einigen hundert Kilohertz und mehreren zehn Gigahertz. Das Plasma wird an den Oberflächen von Elektroden oder Antennen quellförmig erzeugt und breitet sich in den Raum aus. Mit wachsendem Abstand von der Elektrode ändern sich die Zusammensetzung des Plasmas und die Intensität der vom Plasma emittierten Strahlung.

Eine derartige Plasmabehandlung ist zwar bei kleinen Bauteilen angemessen, jedoch eignet sie sich für große Bauteile nicht. Das Plasma tritt nur in einem eng begrenzten Bereich auf und bildet sich nicht über das gesamte Bauteil aus. Zur Plasmabehandlung der gesamten Oberfläche eines großen Bauteils muss daher der Plasmastrahl über das Bauteil geführt werden. Dies ist bei Bauteilen wie beispielsweise Karosserien von Fahrzeugen mit einem hohen Zeit- und Kostenaufwand verbunden.

Eine derartige Plasmabehandlungsanlage zur Beschichtung eines dreidimensionalen Werkstucks wird im Dokument EP-A1- 1 354 640 offenbart.

Darüber hinaus eignen sich die bekannten Verfahren nicht zur Behandlung von Spalten, Fügestellen, Hohlräumen und Hinterschneidungen, welche bei Karosserien von Fahrzeugen auftreten. Die der Plasmaquelle abgewandten Flächen sind keinem gleichmäßigen Plasma ausgesetzt. Auf den der Plasmaquelle zugewandten Flächen kann aufgrund der starken Gradienten eine gleichmäßige Bearbeitung nicht garantiert werden. Dies gilt vor allem für Bearbeitungsvorgänge, die von Strahlungsprozessen dominiert werden.

Demgegenüber haben die erfindungsgemäße Vorrichtung mit den Merkmalen des Anspruchs 1 und das erfindungsgemäße Verfahren mit den Merkmalen des Anspruchs 6 den Vorteil, dass große Bauteile über die gesamte Oberfläche einer gleichmäßig wirkenden Plasmabehandlung unterzogen werden können. Die Behandlung schließt sowohl die Außen- als auch die Innenflächen ein. Spalte, Fügestellen, Hohlräume und Hinterscheidungen werden ebenfalls bearbeitet. Derartige Bereiche treten insbesondere bei Bauteilen auf, welche aus mehreren Elementen zusammengesetzt sind.

Die erfindungsgemäße Vorrichtung und das erfindungsgemäße Verfahren können bei beliebigen Bauteilen unterschiedlicher Größe eingesetzt werden. Sie eignen sich insbesondere für große Bauteile wie beispielsweise Fahrzeugkarosserien, Flugzeug- und Maschinenteilen, um nur einige Beispiele zu nennen. Voraussetzung hierzu ist, dass die Vakuumskammer die notwendige Größe aufweist, und dass die Transportvorrichtung an das Bauteil angepasst ist.

Das Bauteil wird in eine Vakuumkammer der Vorrichtung zur Plasmabehandlung eingebracht. Anschließend wird das Bauteil an einen Schwingkreis mit Hochfrequenzgenerator angeschlossen. Hierzu werden entweder ein Pol oder zwei Pole des Schwingkreises mit dem Bauteil verbunden. Im ersten Fall wird der zweite Pol geerdet. Das Bauteil bildet damit einen Teil des Schwingkreises. Der hochfrequente Wechselstrom fließt durch das Bauteil. Die Induktivität und die Kapazität des Bauteils beeinflussen dabei die Induktivität und die Kapazität des Schwingkreises. Um die optimale Ankopplung der elektrischen Leistung an das Bauteil sicherzustellen, muss der Schwingkreis, der aus dem zu bearbeitenden Bauteil und seinen eigenen Kapazitäten und Induktivitäten besteht, entsprechend angepasst werden. Dies geschieht durch die Variation der Kapazitäten und Induktivitäten des Schwingkreises. Die Einstellung der Kapazitäten und Induktivitäten des Schwingkreises kann entweder manuell oder automatisch erfolgen. Bei einer automatischen Einstellung werden zunächst die Kapazität und die Induktivität des Bauteils ermittelt. Die Variation der Kapazitäten und Induktivitäten der Schwingkreises bewirkt eine Veränderung der Frequenz.

Mit der erfindungsgemäßen Vorrichtung und dem erfindungsgemäßen Verfahren sind unterschiedliche Bearbeitungen des Bauteils möglich. Durch die chemische Wirkung der Plasmapartikel kann eine chemische Bearbeitung der Oberfläche des Bauteils erfolgen. Durch die Plasmastrahlung können die physikalischen Eigenschaften der Oberfläche beeinflusst werden. Hierzu zählt beispielsweise die Vernetzung von UV-Lacken. Durch die Ausbildung von Oberflächenentladungen treten elektrische Effekte an der Oberfläche auf, die zu deren Bearbeitung eingesetzt werden können.

Im Unterschied zu Elektrodenanordnungen muss der Abstand der Elektroden zum Bauteil nicht eingestellt werden. Das Plasma wird durch die Ausbildung von Wirbelströmen an der Oberfläche des Bauteils erzeugt.

Der durch das Bauteil fließende Wechselstrom bewirkt oszillierende Magnetfelder, die sich abhängig von der Geometrie des Bauteils in dessen Umgebung ausbreiten. Die zeitliche Änderung des Magnetfelds führt zu elektrischen Feldern, die für die Erzeugung und Aufrechterhaltung des Plasmas in der Umgebung des Bauteils verantwortlich sind.

Nach einer vorteilhaften Ausgestaltung der Erfindung weist die Transportvorrichtung zum Einbringen des Bauteils in die Vakuumkammer eine oder mehrere Schienen und einen Antrieb auf. Dabei können die Schienen an das Bauteil angepasst werden. An den Schienen oder im Bereich der Schienen ist eine elektrische Isolation vorgesehen um das Bauteil gegen die Vakuumkammer zu isolieren.

Nach einer weiteren vorteilhaften Ausgestaltung der Erfindung weist der Schwingkreis Hochfrequenzleitungen auf. An der Vakuumkammer sind Durchführungen mit elektrischer Isolation für die Hochfrequenzleitungen vorgesehen.

Nach einer weiteren vorteilhaften Ausgestaltung der Erfindung sind in der Vakuumkammer Bleche, Rohre und/ oder Gitter aus Metall vorgesehen. Das Bauteil stellt eine Antenne dar, von der elektromagnetische Wellen in den Raum der Vakuumskammer abgestrahlt werden. Dieser Effekt kann unterstützt werden durch weitere antennenartige Elemente in der Umgebung des Bauteils. Hierzu zählen Bleche oder Gitter aus Metall. Spiralförmig angeordnete Rohre beispielsweise aus Kupfer können diesen Effekt ebenfalls bewirken. In diese Teile koppeln die elektromagnetischen Wellen ein und sorgen für eine zusätzliche Plasmaerzeugung in einem gewissen Abstand vom Bauteil. Auf diese Weise kann der Strahlungsfluss des Plasmas in Richtung auf das Bauteil gesteuert werden.

Nach einer weiteren vorteilhaften Ausgestaltung der Erfindung wird ein Arbeitsgas in die Vakuumkammer gegeben. Dadurch kann der Druck in der Vakuumkammer erhöht werden. Der Druck kann beispielsweise bis zu 1.000 Pa betragen. Das Arbeitsgas tritt mit der Oberfläche des Bauteils chemisch in Wechselwirkung. Als Arbeitsgase können je nach Anforderung verschiedene Gase verwendet werden.

Nach einer weiteren vorteilhaften Ausgestaltung der Erfindung wird eine Flüssigkeit verdampft und über ein Ventil in die Vakuumkammer gegeben. Der Flüssigkeitsdampf erfüllt dieselbe Aufgabe wie die Arbeitsgase.

Nach einer weiteren vorteilhaften Ausgestaltung der Erfindung wird über den Hochfrequenzgenerator eine Wechselspannung mit 0,8 bis 10 MHz in den Schwingkreis eingespeist wird. Besonders bevorzugt liegt die Wechselspannung zwischen 1 und 4 MHz.

Nach einer weiteren vorteilhaften Ausgestaltung der Erfindung wird die Vakuumkammer auf einen Druck zwischen 0,05 und 0,5 Pa evakuiert. Im Unterschied zu den aus dem Stand der Technik bekannten Verfahren kann der Arbeitsdruck je nach Anwendung auf einige 10 mbar erhöht werden. Damit steht ein weiteres Werkzeug zur Steuerung der Zahl der Teilchen, die mit der Oberfläche des zu bearbeitenden Bauteils in Wechselwirkung treten, zur Verfügung. Im Fall des Einsatzes von Arbeitsgasen liegt der Druck in der Kammer wesentlich höher.

Weitere Vorteile und vorteilhafte Ausgestaltungen der Erfindung sind der nachfolgenden Beschreibungen, der Zeichnung und den Ansprüchen zu entnehmen.

In der Zeichnung ist ein Ausführungsbeispiel einer erfindungsgemäßen Vorrichtung zur Plasmabehandlung dargestellt. Im folgenden ist diese Vorrichtung erläutert. Es zeigen:
- Figur 1: Vorrichtung zur Plasmabehandlung in einer Ansicht von vorne,
- Figur 2: Vorrichtung zur Plasmabehandlung in einer Ansicht von oben,
- Figur 3: Schaltplan zur der Vorrichtung gemäß Figur 1 und 2.

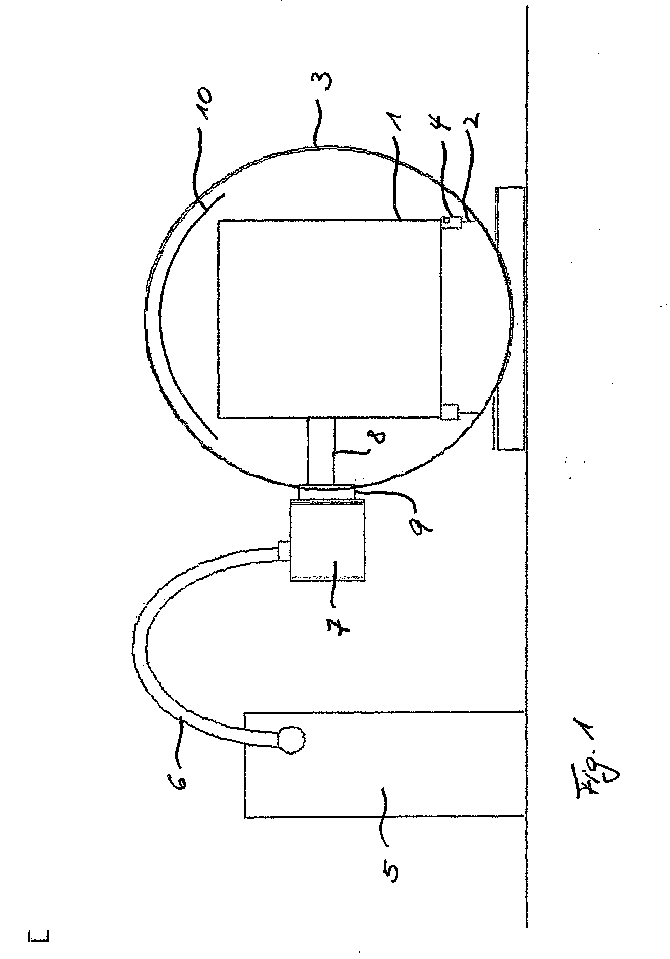

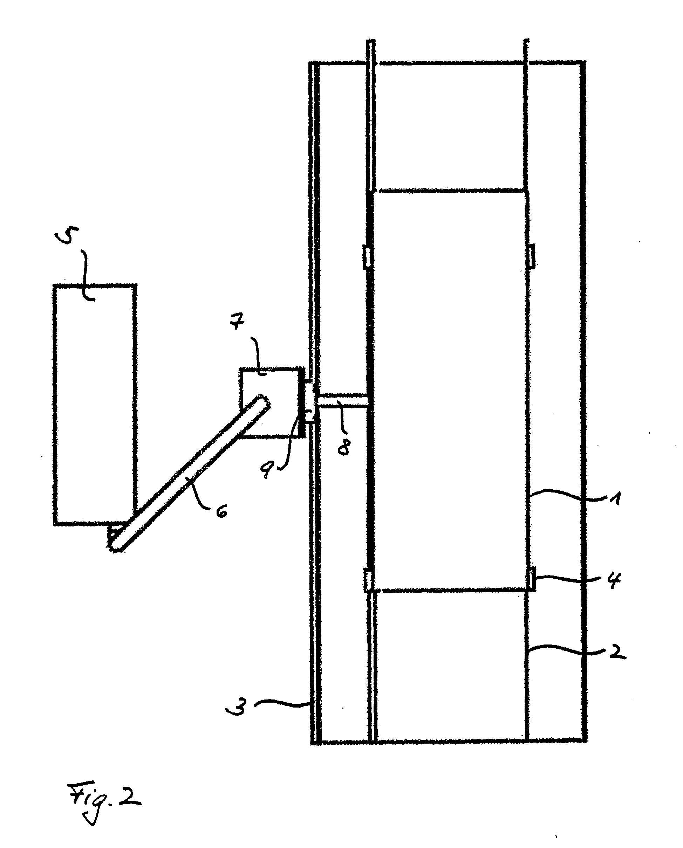

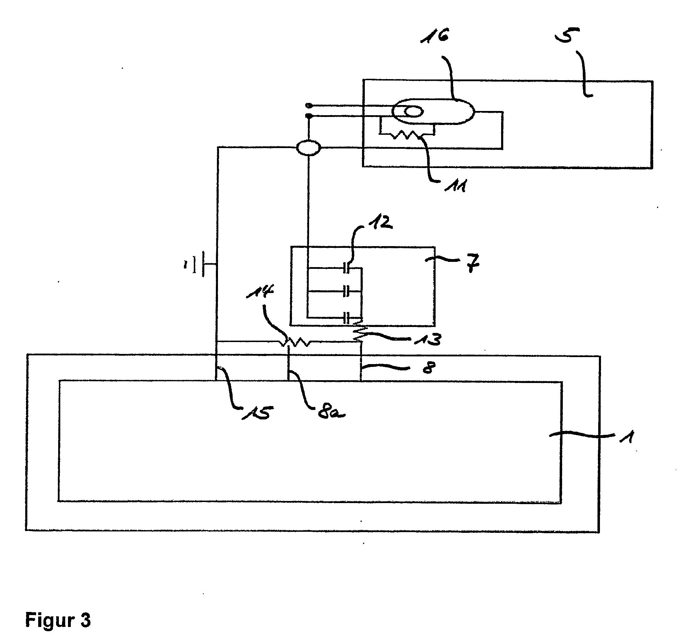

Die Figuren 1 und 2 zeigen eine Vorrichtung zur Plasmabehandlung in einer Ansicht von vorne und von oben. Ein zu bearbeitendes Bauteil 1 wird über Schienen 2 und in der Zeichnung nicht erkennbare Rollen in eine Vakuumkammer 3 eingefahren. An den Schienen 2 ist eine Isolation 4 vorgesehen, welche das Bauteil 1 gegen die Vakuumkammer 3 isoliert. Mit Erreichen seiner Endposition wird der Kontakt zwischen einem Hochfrequenz-Schwingkreis und dem Bauteil geschlossen. Dies erfolgt über einen in der Zeichnung nicht erkennbaren Gleitkontakt, der durch Formschluss an dem Bauteil 1 haftet. Das Bauteil ist nun Teil des Schwingkreises. Der Schwingkreis besteht abgesehen vom Bauteil 1 aus einem Hochfrequenzgenerator 5 mit einer in Figur 3 dargestellten Rückkoppelspule 11, einem Koaxial-Kabel 6, einem Außenschwingkreis 7 und einer Hochfrequenz-Zuleitung 8, an deren Enden der Gleitkontakt vorgesehen ist. In der Vakuumkammer 3 ist eine Hochfrequenz-Durchführung 9 für die Hochfrequenz-Zuleitung 8 vorgesehen. Oberhalb des Bauteils ist ein Reflektor 10 für das Plasma vorgesehen.

Figur 3 zeigt schematisch den Schaltplan der Vorrichtung gemäß Figuren 1 und 2. Die Schaltung ermöglicht die Optimierung der Plasmabehandlung. Der Hochfrequenzgenerator 5 versorgt den Schwingkreis über ein Koaxial-Kabel 6 mit Wechselstrom. Der Hochfrequenzgenerator 5 verfügt über eine Rückkoppelspule 11, deren Induktivität automatisch einstellbar ist. Im Außenschwingkreis 7 sind drei Kondensatoren 12 vorgesehen. Sie können alle oder nur teilweise in den Schwingkreis integriert werden um die Gesamtkapazität zu verändern. Die Induktivität des Schwingkreises wird im wesentlichen durch das Bauteil 1 bestimmt. Das Bauteil 1 ist über die Hochfrequenz-Zuleitung 8 mit dem Außenschwingkreis 7 verbunden. Um die Induktivität des Schwingkreises auf das Bauteil abzustimmen, ist eine Spule 13 am Außenschwingkreis vorgesehen. Zusätzlich dazu ist eine weitere Spule 14 mit einem Abgriff an der Hochfrequenz-Zuleitung 8 unmittelbar an der Spule 13 vorgesehen. Diese wird nur bei Bedarf zur Anpassung der Gesamtinduktivität in den Schwingkreis integriert. Für diesen Fall wird anstelle der Hochfrequenz-Zuleitung 8 die Hochfrequenz-Zuleitung 8a verwendet. Das Bauteil 1 kann optional über die Erdleitung 15 geerdet werden.

Durch Einspeisen eines hochfrequenten Wechselstroms bei sehr niedriger Leistung wird der Kontakt zwischen Bauteil 1 und Schwingkreis überprüft. Erfüllt der Kontakt die Anforderungen, so wird die Vakuumkammer 3 evakuiert. Nachdem der Druck in der Vakuumkammer 3 einen bestimmten, von der Art der Behandlung abhängigen Wert erreicht hat, wird hochfrequenter Wechselstrom in den Schwingkreis eingespeist. An der Oberfläche des Bauteils 1 entsteht das Plasma, welches für die Behandlung des Bauteils benötigt wird. Die Steuerung des Plasmaeinflusses an der Oberfläche des Bauteils erfolgt durch die Regelung der Anodenspannung einer Senderöhre 16, die den Wechselstrom in den Schwingkreis einspeist. Die Senderöhre ist in der Zeichnung nicht dargestellt. Durch Überwachung der Strom-Spannungskennlinie der Senderöhre 16 des Schwingkreises wird die Effizienz der Einkopplung der elektrischen Leistung in das Plasma kontrolliert. Die Feinabstimmung des Schwingkreises während der Plasmabehandlung erfolgt durch Variation der Induktivität der Rückkoppelspule des Schwingkreises. Im Vorfeld besteht zusätzlich die Möglichkeit, die Grobabstimmung des Systems durch Einfügen zusätzlicher Induktivitäten 14 oder Kapazitäten 12 in den Schwingkreis auf das zu bearbeitende Bauteil vorzunehmen. Nach der Plasmabehandlung wird die Vakuumkammer 3 belüftet. Der Kontakt zum Schwingkreis wird gelöst und das Bauteil 1 wird aus der Vakuumkammer 3 transportiert.

### Bezugszeichen

- 1: Bauteil
- 2: Schiene
- 3: Vakuumkammer
- 4: Isolation
- 5: Hochfrequenzgenerator
- 6: Koaxial-Kabel
- 7: Außenschwingkreis
- 8: Hochfrequenz-Zuleitung
- 9: Hochfrequenz-Durchführung
- 10: Reflektor
- 11: Rückkoppelspule
- 12: Kondensator des Außenschwingkreises
- 13: Spule
- 14: Spule
- 15: Erdleitung
- 16: Senderöhre

## Patentansprüche

1. Vorrichtung zur Plasmabehandlung großvolumiger Bauteile
mit einer Vakuumkammer (3) mit einer oder mehreren Pumpen,
mit einer Transportvorrichtung (2) zum Befördern des Bauteils (1) in die Vakuumkammer (3),
mit einer Isolation (4) zwischen dem Bauteil (1) und der Vakuumkammer (3), **dadurch gekennzeichnet, dass**
ein Schwingkreis mit einem Hochfrequenzgenerator (5),
eine einstellbare Kapazität und eine einstellbare Induktivität des Schwingkreises, und
mindestens ein Anschluss zum Verbinden des Schwingkreises mit dem Bauteil (1) vorgesehen sind.

2. Vorrichtung nach Anspruch 1, **dadurch gekennzeichnet, dass** die Transportvorrichtung eine oder mehrere Schienen (2) und einen Antrieb aufweist.

3. Vorrichtung nach Anspruch 2, **dadurch gekennzeichnet, dass** die Schienen (2) eine elektrische Isolation (4) aufweisen, welche das Bauteil (1) gegen die Vakuumkammer (3) isoliert.

4. Vorrichtung nach Anspruch 1, 2 oder 3, **dadurch gekennzeichnet, dass** der Schwingkreis eine oder mehrere Hochfrequenzleitungen (8) aufweist, und dass an der Vakuumkammer (3) Hochfrequenz-Durchführungen (9) mit elektrischer Isolation für die Hochfrequenzleitungen vorgesehen sind.

5. Vorrichtung nach einem der vorhergehenden Ansprüche, **dadurch gekennzeichnet, dass** in der Vakuumkammer (3) Bleche (10) und/ oder Gitter aus Metall vorgesehen sind.

6. Vorrichtung nach einem der vorhergehenden Ansprüche, **dadurch gekennzeichnet, dass** der Hochfrequenzgenerator (5) eine Rückkoppelspule (11) mit einstellbarer Induktivität aufweist.

7. Vorrichtung nach einem der vorhergehenden Ansprüche, **dadurch gekennzeichnet, dass** über Schalter mit dem Schwingkreis verbundene Kapazitäten (12) und/ oder Induktivitäten (14) vorgesehen sind zur Abstimmung der Kapazität und/ oder der Induktivität des Schwingkreises auf das Bauteil (1).

8. Vorrichtung nach einem der vorhergehenden Ansprüche, **dadurch gekennzeichnet, dass** eine Senderöhre (16) zur Einspeisung des Wechselstroms in den Schwingkreis vorgesehen ist.

9. Verfahren zur Plasmabehandlung großvolumiger Bauteile-insbesondere unter Verwendung einer Vorrichtung nach einem der vorhergehenden Ansprüche,
dass das Bauteil (1) in einer Vakuumkammer (3) angeordnet und die Vakuumkammer evakuiert wird, **dadurch gekennzeichnet,**
**dass** das Bauteil (1) an einen Schwingkreis mit einem Hochfrequenzgenerator (5) angeschlossen wird,
**dass** die Induktivität und/ oder die Kapazität des Schwingkreises auf das Bauteil (1) abgestimmt wird.

10. Verfahren nach Anspruch 9, **dadurch gekennzeichnet, dass** der Kontakt zwischen dem Bauteil (1) und dem Schwingkreis durch Einspeisen eines hochfrequenten Wechselstroms bei niedriger Leistung in den Schwingkreis überprüft wird.

11. Verfahren nach Anspruch 9 oder 10, **dadurch gekennzeichnet, dass** ein Arbeitsgas in die Vakuumkammer (3) gegeben wird.

12. Verfahren nach Anspruch 9 oder 10, **dadurch gekennzeichnet, dass** eine Flüssigkeit verdampft und über ein Ventil in die Vakuumkammer gegeben wird.

13. Verfahren nach einem der Ansprüche 9 bis 12, **dadurch gekennzeichnet, dass** über den Hochfrequenzgenerator (5) eine Wechselspannung mit 0,8 bis 10 MHz in den Schwingkreis eingespeist wird.

14. Verfahren nach einem der Ansprüche 9 bis 13, **dadurch gekennzeichnet, dass** die Vakuumkammer (3) auf einen Druck zwischen 0,05 und 0,5 Pa evakuiert wird.

15. Verfahren nach einem der Ansprüche 9 bis 14, **dadurch gekennzeichnet, dass** in der Vakuumkammer (3) Bleche (10) und/ oder Gitter positioniert werden.

16. Verfahren nach einem der Ansprüche 9 bis 15, **dadurch gekennzeichnet, dass** das Plasma an der Oberfläche des Bauteils (1) durch Variation der Anodenspannung einer Senderöhre, welche den Wechselstrom in den Schwingkreis einspeist, eingestellt wird.

17. Verfahren nach einem der Ansprüche 9 bis 16, **dadurch gekennzeichnet, dass** zur Grobabstimmung des Schwingkreises auf das Bauteil (1) zusätzliche Kapazitäten (12) und/ oder Induktivitäten (14) in den Schwingkreis eingesetzt werden.

18. Verfahren nach einem der Ansprüche 9 bis 17, **dadurch gekennzeichnet, dass** zur Feinabstimmung des Schwingkreises auf das Bauteil (1) die Induktivität der Rückkoppelspule (11) des Schwingkreises variiert wird.

19. Verfahren nach einem der Ansprüche 9 bis 18, **dadurch gekennzeichnet,**
**dass** die Induktivität und die Kapazität des Bauteils (1) bestimmt werden und dass die Induktivität und die Kapazität des Schwingkreises an die Induktivität und Kapazität des Bauteils angepasst werden.

## Claims

1. Device for plasma treatment of large-scale components with a vacuum chamber (3), with one or more pumps, with a transport device (2) for conveying the component (1) into the vacuum chamber (3),
with isolation (4) between the component (1) and the vacuum chamber (3),
**characterised in that**,
a resonant circuit with a high-frequency generator (5),
an adjustable capacitance and an adjustable inductance of the resonant circuit, and at least one terminal for connecting the resonant circuit with the component (1)
are provided.

2. Device according to claim 1, **characterized in that** the transport device comprises one or more rails (2) and a drive system.

3. Device according to claim 2, **characterized in that** the rails (2) comprise electrical isolation (4) which isolates the component (1) with respect to the vacuum chamber (3).

4. Device according to claim 1, 2 or 3, **characterized in that** the resonant circuit comprises one or multiple high-frequency lines (8) and that the vacuum chamber (3) is provided with high-frequency bushings (9) with electrical isolation for the high-frequency lines.

5. Device according to one of the preceding claims, **characterized in that** the vacuum chamber (3) is provided with metal plates (10) and/or grids.

6. Device according to one of the preceding claims, **characterized in that** the high-frequency generator (5) comprises a feedback coil (11) with adjustable inductance.

7. Device according to one of the preceding claims, **characterized in that** capacitances (12) and/ or inductances (14), connected via switches with the resonant circuit are provided to tune the capacitance and /or the inductance of the resonant circuit to the component (1).

8. Device according to one of the preceding claims, **characterized in that** a transmitting tube (16) for feeding the alternating current into the resonant circuit is provided.

9. Method for plasma treatment of large-scale components, in particular by using a device according to one of the preceding claims, wherein the component (1) is positioned in a vacuum chamber (3) and the vacuum chamber is evacuated,
**characterised in that**
the component (1) is connected to a resonant circuit with a high-frequency generator (5),
the inductance and/or the capacitance of the resonant circuit is tuned to the component (1).

10. Method according to claim 9, **characterized in that** the contact between the component (1) and the resonant circuit is monitored by feeding a high-frequency alternating current at low power into the resonant circuit.

11. Method according to claim 9 or 10, **characterized in that** a process gas is fed into the vacuum chamber (3).

12. Method according to claim 9 or 10, **characterized in that** a liquid is vaporized and fed into the vacuum chamber through a valve.

13. Method according to one of claims 9 through 12, **characterized in that** an alternating voltage at 0.8 to 10 MHz is fed into the resonant circuit via the high-frequency generator (5).

14. Method according to one of claims 9 through 13, **characterized in that** the vacuum chamber (3) is evacuated to a pressure between 0.05 and 0.5 Pa.

15. Method according to one of claims 9 through 14, **characterized in that** panels (10) and/ or grids are positioned in the vacuum chamber (3).

16. Method according to one of claims 9 through 15, **characterized in that** the plasma on the surface of the component (1) is adjusted by variation of the anode voltage of a transmitting tube which feeds the alternating current into the resonant circuit.

17. Method according to one of the claims 9 through 16, **characterized in that** additional capacitances (12) and/or inductances (14) in the resonant circuit are used for the rough tuning of the resonant circuit to the component (1).

18. Method according to one of claims 9 through 17, **characterized in that** the inductance of the feedback coil (11) of the resonant circuit is varied for the fine-tuning of the resonant circuit to the component (1).

19. Method according to one of claims 9 through 18, **characterized in that** the
inductance and the capacitance of the component (1) are determined, and the
inductance and the capacitance of the resonant circuit are adjusted to the
inductance and capacitance of the component.

## Revendications

1. Dispositif de traitement par plasma de composants à grand volume comprenant une chambre à vide (3) dotée d'une ou de plusieurs pompes, comprenant un dispositif de transport (2) destiné au transport du composant (1) dans la chambre à vide (3),
comprenant une isolation (4) entre le composant (1) et la chambre à vide (3), **caractérisé par le fait que**
un circuit oscillant avec un oscillateur haute fréquence (5),
une capacité réglable et une inductance réglable du circuit oscillant, et
au moins un raccord pour la connexion du circuit oscillant avec le composant (1) sont prévus.

2. Dispositif selon la revendication 1, **caractérisé par le fait que** le dispositif de transport est équipé d'un ou de plusieurs rails (2) et d'un entraînement.

3. Dispositif selon la revendication 2, **caractérisé par le fait que** les rails (2) sont dotés d'une isolation électrique (4) qui isole le composant (1) de la chambre à vide (3).

4. Dispositif selon la revendication 1, 2 ou 3, **caractérisé par le fait que** le circuit oscillant est doté d'un ou de plusieurs câble(s) haute fréquence (8) et que des passages haute fréquence (9) avec isolation électrique pour les câbles haute fréquence sont prévus au niveau de la chambre à vide (3).

5. Dispositif selon l'une quelconque des revendications précédentes, **caractérisé par le fait que** des tôles (10) et/ou des grilles en métal sont prévues dans la chambre à vide (3).

6. Dispositif selon l'une quelconque des revendications précédentes, **caractérisé par le fait que** l'oscillateur haute fréquence (5) est doté d'une bobine d'asservissement (11) à inductance réglable.

7. Dispositif selon l'une quelconque des revendications précédentes, **caractérisé par le fait que** des condensateurs (12) et/ou des bobines d'induction (14) reliés au circuit oscillant par des commutateurs sont prévus pour le réglage de la capacité et/ou de l'inductance du circuit oscillant en fonction du composant (1).

8. Dispositif selon l'une quelconque des revendications précédentes, **caractérisé par le fait que** qu'un tube émetteur (16) est prévu pour l'alimentation en courant alternatif du circuit oscillant.

9. Procédé de traitement par plasma de composants à grand volume utilisant notamment un dispositif selon l'une quelconque des revendications précédentes,
le composant (1) étant disposé dans une chambre à vide (3) et le vide étant fait dans la chambre à vide, **caractérisé par le fait que**,
le composant (1) est raccordé à un circuit oscillant avec un oscillateur haute fréquence (5),
l'inductance et/ou la capacité du circuit oscillant sont adaptées en fonction du composant (1).

10. Procédé selon la revendication 9, **caractérisé par le fait que** le contact entre le composant (1) et le circuit oscillant est contrôlé par l'alimentation dans le circuit oscillant d'un courant alternatif haute fréquence avec une puissance faible.

11. Procédé selon la revendication 9 ou 10, **caractérisé par le fait qu'**un gaz de travail est introduit dans la chambre à vide (3).

12. Procédé selon la revendication 9 ou 10, **caractérisé par le fait qu'**un liquide s'évapore et est introduit dans la chambre à vide par le biais d'une valve.

13. Procédé selon l'une des revendications 9 à 12, **caractérisé par le fait que** le circuit oscillant est alimenté avec une tension alternative de 0,8 à 10 MHz par l'oscillateur haute fréquence (5).

14. Procédé selon l'une des revendications 9 à 13, **caractérisé par le fait que** la chambre à vide (3) est vidée à une pression située entre 0,05 et 0,5 Pa.

15. Procédé selon l'une des revendications 9 à 14, **caractérisé par le fait que** des tôles (10) et/ou des grilles sont placées dans la chambre à vide (3).

16. Procédé selon l'une des revendications 9 à 15, **caractérisé par le fait que** le plasma à la surface du composant (1) est réglé par une variation de la tension anodique d'un tube émetteur qui alimente le circuit oscillant en courant alternatif.

17. Procédé selon l'une des revendications 9 à 16, **caractérisé par le fait que** pour le réglage grossier du circuit oscillant en fonction du composant (1), des condensateurs (12) et/ou des bobines d'induction (14) supplémentaires sont utilisés dans le circuit oscillant.

18. Procédé selon l'une des revendications 9 à 17, **caractérisé par le fait que** le réglage précis du circuit oscillant en fonction du composant (1) est effectué par une variation de l'inductance de la bobine d'asservissement (11) du circuit oscillant.

19. Procédé selon l'une des revendications 9 à 18, **caractérisé par le fait que** l'inductance et la capacité du composant (1) sont déterminées et que l'inductance et la capacité du circuit oscillant sont adaptées à l'inductance et à la capacité du composant.
